# EUROPEAN PATENT APPLICATION

(11) **EP 1 944 165 A2**
(43) Date of publication of application: **16.07.2008**
(21) Application number: 08000484.9
(22) Date of filing: 11.01.2008
(51) Int. Cl.: B41J 2/14

(54) **Acutator device and liquid ejecting head including the same**

(30) Priority: 15.01.2007 JP 2007005593
(71) Applicant: Seiko Epson Corporation, Shinjuku-ku, Tokyo 163-0811 (JP)
(72) Inventor: Li, Xin-Shan, Suwa-shi Nagano-ken 392-8502 (JP)
(74) Representative: HOFFMANN EITLE

(57) **Abstract**

An actuator device includes a piezoelectric element including a lower electrode (60), a piezoelectric layer (70), and an upper electrode (80) that are displaceably provided in sequence on a substrate. The lower electrode includes a flat portion at a central region thereof and an inclined portion at an end thereof descending toward the substrate. The piezoelectric layer is disposed above the lower electrode and the substrate, and includes a first piezoelectric layer portion constituted by a plurality of columnar crystals (710) extending orthogonally to a surface of the flat portion of the lower electrode, a second piezoelectric layer portion constituted by a plurality of columnar crystals (720) extending orthogonally to a surface of the substrate, and a third piezoelectric layer portion constituted by a plurality of columnar crystals (730) residing on the inclined portion between the first and second piezoelectric layer portions. The columnar crystals of the third piezoelectric layer portion extend orthogonally to a surface of the inclined portion and bend toward the upper electrode so as to extend orthogonally to the surface of the substrate. Grains of the columnar crystals constituting the third piezoelectric layer portion have larger widths than those of grains of the columnar crystals constituting the first and second piezoelectric layer portions at a surface of the piezoelectric layer proximate to the upper electrode.

## Description

### BACKGROUND

### 1. Technical Field

The present invention relates to actuator devices having vibrating plates and piezoelectric elements that are displaceably provided on a substrate, and also relates to liquid ejecting heads including the actuator devices.

### 2. Related Art

Examples of a piezoelectric element included in an actuator device include a structure in which a piezoelectric material functioning as an electromechanical transducer, such as a piezoelectric layer made of a crystallized dielectric material, is disposed between two electrodes, a lower electrode and an upper electrode. Such an actuator device is called, in general, a flexural-oscillation-mode actuator device, and is used as a component of a liquid ejecting head, for example. Typical examples of the liquid ejecting head include an ink jet recording head in which ink droplets are ejected through nozzle openings by utilizing deformation of vibrating plates, which constitute part of pressure-generating chambers communicating with the nozzle openings, caused by piezoelectric elements so as to pressurize the ink in the pressure-generating chambers. Examples of the actuator device included in the ink jet recording head include a device in which a piezoelectric element is formed independently for each of the pressure-generating chambers by lithographically dividing a piezoelectric material layer, which is uniformly deposited over the entire surface of the vibrating plates, in correspondence with the pressure-generating chambers.

JP-A-2002-314163, JP-A-2002-319714, and JP-A-2003-174211 disclose examples of such a piezoelectric element including a lower electrode disposed on a substrate, a piezoelectric layer disposed on the lower electrode, and an upper electrode disposed on the piezoelectric layer such that an end face of the lower electrode and the top surface of the substrate become perpendicular to each other.

These examples, however, have a problem that actuation of an actuator device including the above-described piezoelectric element may cause cracks in the piezoelectric layer because a concentrated stress occurs at the boundary between an active piezoelectric region, a portion provided between the upper electrode and the lower electrode, and an inactive piezoelectric region, the remaining portion.

### SUMMARY

An advantage of some aspects of the invention is that it provides an actuator device including a piezoelectric layer having a high strength against a stress occurring upon application of a voltage to a pair of electrodes, and also provides a liquid ejecting head including the actuator device.

According to a first aspect of the invention, an actuator device includes a piezoelectric element including a lower electrode, a piezoelectric layer, and an upper electrode that are displaceably provided in sequence on a substrate. The lower electrode includes a flat portion at a central region thereof and an inclined portion at an end thereof descending toward the substrate. The piezoelectric layer is disposed above the lower electrode and the substrate, and includes a first piezoelectric layer portion constituted by a plurality of columnar crystals extending orthogonally to a surface of the flat portion of the lower electrode, a second piezoelectric layer portion constituted by a plurality of columnar crystals extending orthogonally to a surface of the substrate, and a third piezoelectric layer portion constituted by a plurality of columnar crystals residing on the inclined portion between the first and second piezoelectric layer portions. The columnar crystals of the third piezoelectric layer portion extend orthogonally to a surface of the inclined portion and bend toward the upper electrode so as to extend orthogonally to the surface of the substrate. Grains of the columnar crystals constituting the third piezoelectric layer portion have larger widths than those of grains of the columnar crystals constituting the first and second piezoelectric layer portions at a surface of the piezoelectric layer proximate to the upper electrode.

In the first aspect of the invention, the columnar crystals constituting the piezoelectric layer portion at the intermediate piezoelectric region have a high strength against a stress applied in a direction from the lower electrode toward the upper electrode or in the opposite direction. Thus, a highly reliable and durable actuator device can be provided.

It is preferable that the piezoelectric element include an active piezoelectric region constituted by the first piezoelectric layer portion, an inactive piezoelectric region constituted by the second piezoelectric layer portion, and an intermediate piezoelectric region constituted by the third piezoelectric layer portion. The presence of the intermediate piezoelectric region constituted by highly strong columnar crystals relaxes a stress occurring at the boundary between the active piezoelectric region and the inactive piezoelectric region. Thus, a more highly reliable and durable actuator device can be provided.

It is also preferable that the grains of the columnar crystals constituting the third piezoelectric layer portion have larger widths than those of the grains of the columnar crystals constituting the first and second piezoelectric layer portions in the same direction. This provides the columnar crystals constituting the piezoelectric layer portion at the intermediate piezoelectric region with a higher strength against a stress applied in a direction from the lower electrode toward the upper electrode or in the opposite direction. Thus, a more highly reliable and durable actuator device can be provided.

It is also preferable that a width direction of the grains of the columnar crystals constituting the third piezoelectric layer portion correspond to an inclined direction of the inclined portion. This provides the columnar crystals constituting the piezoelectric layer portion at the intermediate piezoelectric region with a high strength against a stress applied in the inclined direction of the inclined portion from the lower electrode toward the upper electrode or in the opposite direction. Thus, a more highly reliable and durable actuator device can be provided.

It is also preferable that the inclined portion be inclined at 5 to 50 degrees with respect to the surface of the substrate. This provides the columnar crystals constituting the piezoelectric layer portion at the intermediate piezoelectric region with a higher strength against a stress applied in the inclined direction of the inclined portion from the lower electrode toward the upper electrode or in the opposite direction.

It is also preferable that the inclined portion have a length of 0.5 to 3 µm in the inclined direction. This provides the columnar crystals constituting the piezoelectric layer portion at the intermediate piezoelectric region with a higher strength against a stress applied in the inclined direction of the inclined portion from the lower electrode toward the upper electrode or in the opposite direction.

It is also preferable that the columnar crystals respectively constituting the first to third piezoelectric layer portions have perovskite structures. This provides the columnar crystals constituting the piezoelectric layer portion at the intermediate piezoelectric region with a higher strength against a stress applied in a direction from the lower electrode toward the upper electrode or in the opposite direction.

According to a second aspect of the invention, a liquid ejecting head includes a channel-forming substrate provided with a pressure-generating chamber communicating with a nozzle opening through which liquid is ejected, and the actuator device according to the first aspect of the invention serving as a liquid ejecting unit that is provided on one surface of the channel-forming substrate and causes a change of pressure in the pressure-generating chamber.

The liquid ejecting head according to the second aspect of the invention includes the actuator device having the intermediate piezoelectric region constituted by columnar crystals having a high strength. Thus, a highly reliable and durable liquid ejecting head can be provided.

### BRIEF DESCRIPTION OF THE DRAWINGS

The invention will be described with reference to the accompanying drawings, wherein like numbers reference like elements.

Fig. 1 is a schematic exploded perspective view of a recording head according to a first embodiment.

Fig. 2A is a plan view of the recording head according to the first embodiment.

Fig. 2B is a sectional view of the recording head according to the first embodiment.

Fig. 3 is an enlarged sectional view of a piezoelectric element according to the first embodiment.

Fig. 4 schematically shows a surface taken along plane IV-IV in Fig. 3.

### DESCRIPTION OF EXEMPLARY EMBODIMENTS

Embodiments of the invention will now be described in detail with reference to the drawings.

### First Embodiment

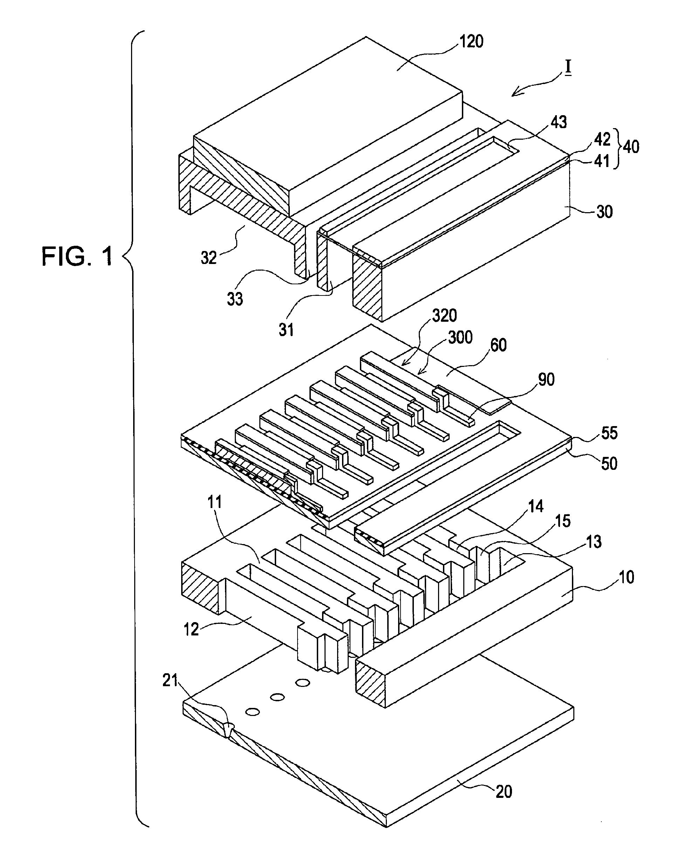

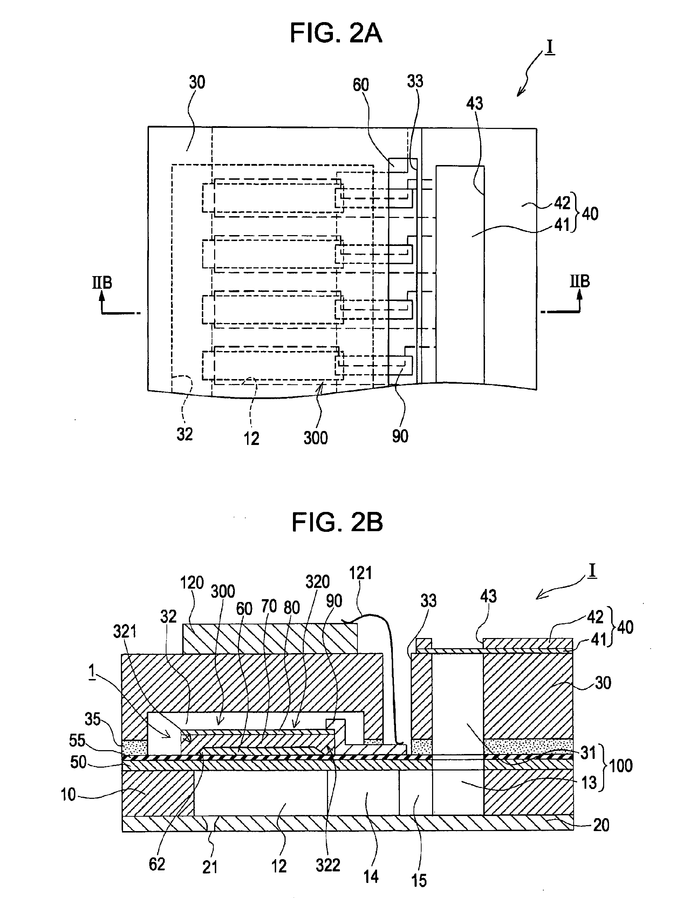

Fig. 1 is a schematic exploded perspective view of an ink jet recording head I as an example of a liquid ejecting head according to a first embodiment of the invention. Figs. 2A and 2B are a plan view and a sectional view of the same, respectively, the sectional view being taken along line IIB-IIB in Fig. 1.

Referring to the drawings, in the first embodiment, a channel-forming substrate 10 as a substrate is made of a silicon single crystal having a (110) crystal plane orientation. An elastic film 50 composed of silicon dioxide and having a thickness of 0.5 µm to 2 µm is preliminarily provided on a surface of the channel-forming substrate 10 by thermal oxidation.

The channel-forming substrate 10 has pressure-generating chambers 12 arranged parallel with each other in the width direction (lateral direction) of the channel-forming substrate 10. The pressure-generating chambers 12 are defined by a plurality of partitions 11 that are formed by performing anisotropic etching on the other surface of the channel-forming substrate 10. Each of the partitions 11 further defines an ink supply channel 14 and a communicating channel 15 at an end in the longitudinal direction of a corresponding one of the pressure-generating chambers 12 of the channel-forming substrate 10. Each of the communicating channels 15 communicates at its one end with a communicating region 13 constituting a part of a reservoir 100 that serves as a common ink chamber (liquid chamber) for the pressure-generating chambers 12. In short, the channel-forming substrate 10 has liquid channels each including the pressure-generating chamber 12, the communicating region 13, the ink supply channel 14, and the communicating channel 15.

The ink supply channel 14 communicates with a longitudinal end of the corresponding pressure-generating chamber 12 and has a cross-section smaller than that of the pressure-generating chamber 12.

A nozzle plate 20 has nozzle openings 21 bored therein, each of which communicates with the vicinity of an end of the corresponding pressure-generating chamber 12 opposite the end communicating with the ink supply channel 14. The nozzle plate 20 is bonded to an open surface of the channel-forming substrate 10 with an adhesive, a heat welding film, or the like. The nozzle plate 20 is made of, for example, a glass-ceramic plate, a silicon single-crystal substrate, or a stainless steel plate.

As described above, the elastic film 50 composed of silicon dioxide and having a thickness of, for example, about 1.0 µm is provided on a surface of the channel-forming substrate 10 opposite the open surface. An insulator film 55 composed of zirconium oxide (ZrO₂) or the like, and having a thickness of, for example, about 0.4 µm is deposited on the elastic film 50.

The insulator film 55 supports a plurality of stacks each including a lower electrode film 60 having a thickness of about 0.1 µm to 0.5 µm; a piezoelectric layer 70, which is a dielectric film and is to be described below in detail, composed of lead zirconate titanate (PZT) or the like and having a thickness of about 1.1 µm; and an upper electrode film 80 composed of gold, platinum, iridium, or the like and provided with a thickness of about 0.05 µm, for example, so as to cover the lower electrode film 60 together with the piezoelectric layer 70 disposed therebetween.
These stacks serve as piezoelectric elements 300. In the first embodiment, the lower electrode film 60 extends across all regions corresponding to the pressure-generating chambers 12, thereby serving as a common electrode for the piezoelectric elements 300. The lower electrode film 60 has inclined portions 62 at its ends in a direction in which the pressure-generating chambers 12 extend. The inclined portions 62 extend downward from the top surface of the lower electrode film 60 toward the channel-forming substrate 10. The piezoelectric layers 70 and the upper electrode films 80 extend beyond the inclined portions 62 so as to cover portions of the lower electrode film 60 in correspondence with the piezoelectric elements 300, whereby the upper electrode films 80 serve as individual electrodes for the piezoelectric elements 300. In the first embodiment, the elastic film 50, the insulator film 55, and the lower electrode film 60 constitute a vibrating plate. Further, the vibrating plate and each piezoelectric element 300 constitute an actuator device 1. Herein, the piezoelectric element 300 refers to a structure including the lower electrode film 60, the piezoelectric layer 70, and the upper electrode film 80. In the first embodiment, the lower electrode film 60 serves as a common electrode for all the piezoelectric elements 300, and the upper electrode films 80 serve as individual electrodes for the piezoelectric elements 300. However, their roles may also be reversed in view of the arrangement of the driving circuit or wiring. In either case, an active piezoelectric region 320 is provided for each of the pressure-generating chambers 12.

The piezoelectric layer 70 of the first embodiment is, for example, a crystal film provided on the lower electrode film 60 and having a perovskite structure made of a ferroelectric ceramic material functioning as an electromechanical transducer. The piezoelectric layer 70 is preferably composed of, for example, a ferroelectric-piezoelectric material such as lead zirconate titanate (PZT), or a mixture of the ferroelectric-piezoelectric material and a metaloxide such as niobium oxide, nickel oxide, or magnesium oxide. Specifically, lead titanate (PbTiO₃), lead zirconate titanate (Pb(Zr,Ti)O₃), lead zirconate (PbZrO₃), lead lanthanum titanate ((Pb,La),TiO₃), lead lanthanum zirconate titanate ((Pb,La)(Zr,Ti)O₃), lead zirconate titanate magnesium niobate (Pb(Zr,Ti) (Mg,Nb)O₃), or the like can be used. The piezoelectric layer 70 of the first embodiment is composed of lead zirconate titanate (PZT).

The upper electrode film 80 that serves as the individual electrode of the piezoelectric element 300 is provided with a lead electrode 90 composed of gold (Au), for example, connected at an end of the upper electrode film 80 near the ink supply channel 14 and extending down onto the insulator film 55.

The channel-forming substrate 10 having the piezoelectric elements 300 provided thereon has a protective substrate 30 bonded together with an adhesive 35 therebetween. The protective substrate 30 has a reservoir section 31 constituting at least a part of the reservoir 100. The reservoir section 31 of the first embodiment penetrates the protective substrate 30 thicknesswise and extends in the protective substrate 30 in the transverse direction of the pressure-generating chambers 12, thereby communicating with the communicating region 13. As described above, the reservoir section 31 and the communicating region 13 in the channel-forming substrate 10 communicate with each other and constitute the reservoir 100 that serves as the common liquid chamber of the pressure-generating chambers 12. It is also possible that the communicating region 13 in the channel-forming substrate 10 is divided into compartments corresponding to the pressure-generating chambers 12 to make only the reservoir section 31 serve as the reservoir. It is also possible that, for example, only the pressure-generating chambers 12 are provided in the channel-forming substrate 10 and that the ink supply channels 14 communicating with the reservoir and the pressure-generating chambers 12 are provided in a member interposed between the channel-forming substrate 10 and the protective substrate 30 (for example, the elastic film 50 and the insulator film 55).

The protective substrate 30 has a piezoelectric-element retaining section 32, which has an internal space large enough not to hinder operation of the piezoelectric elements 300, provided in a region over the piezoelectric elements 300. The piezoelectric-element retaining section 32 may be either sealed or unsealed, as long as it provides an internal space large enough not to hinder operation of the piezoelectric elements 300.

The protective substrate 30 is preferably made of, for example, glass or ceramics having a coefficient of thermal expansion substantially equivalent to that of the channel-forming substrate 10. In the first embodiment, the protective substrate 30 is made of the same material as the channel-forming substrate 10, i.e., a silicon single-crystal substrate.

Further, a penetrating-opening 33 extending in the thickness direction of the protective substrate 30 is provided. Tips of the lead electrodes 90 extending from the piezoelectric elements 300 are exposed through the penetrating-opening 33.

Further, a driving circuit 120 that drives the piezoelectric elements 300 is mounted on the protective substrate 30. The driving circuit 120 may be, for example, a circuit substrate, a semiconductor integrated circuit (IC), or the like. The driving circuit 120 and the lead electrodes 90 are electrically connected by the connecting wire 121 made of a conductive wire such as a bonding wire.

Further, a compliance substrate 40 including a sealing film 41 and a fixing plate 42 is bonded to the protective substrate 30. The sealing film 41 is made of a flexible material having a low rigidity (for example, a polyphenylene sulfide (PPS) film having a thickness of 6 µm). The sealing film 41 seals the reservoir section 31 from one side. The fixing plate 42 is made of a hard material such as metal (for example, a stainless steel (SUS) plate having a thickness of 30 µm). A region of the fixing plate 42 facing the reservoir 100 is completely removed in the thickness direction to provide an opening 43. The reservoir 100 is sealed solely by the flexible sealing film 41 from one side.

In the ink jet recording head I according to the first embodiment, ink is supplied from an external ink supply unit (not shown) to fill the inside of the ink jet recording head I from the reservoir 100 to the nozzle openings 21. The driving circuit 120 sends a recording signal to apply a voltage between the lower electrode film 60 and the upper electrode films 80 of the pressure-generating chambers 12. This causes the elastic film 50, the insulator film 55, the lower electrode film 60, and the piezoelectric layers 70 to be deflected and increases the pressure in the pressure-generating chambers 12, thereby causing ink droplets to be ejected through the nozzle openings 21.

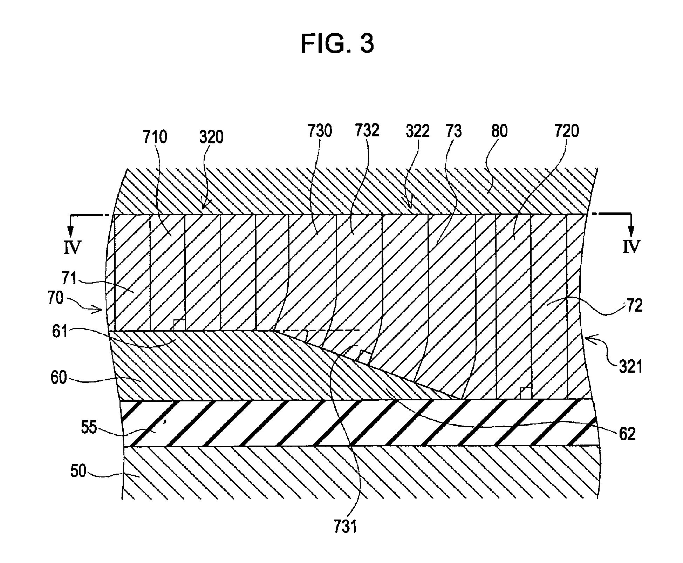

Next, the piezoelectric layer 70 constituting the above-mentioned piezoelectric element 300 will be described in detail. Referring to Fig. 3, which is an enlarged sectional view of the piezoelectric element 300 according to the first embodiment of the invention, the piezoelectric layer 70 includes three types of portions, i.e., first to third piezoelectric layer portions 71 to 73.

The first piezoelectric layer portion 71 resides on a flat portion 61 of the lower electrode film 60. The flat portion 61 has a top surface parallel with the surface of the insulator film 55. The first piezoelectric layer portion 71 includes a plurality of columnar crystals 710 extending orthogonally to the top surface of the lower electrode film 60. The second piezoelectric layer portion 72 resides on the insulator film 55 and includes a plurality of columnar crystals 720 extending orthogonally to the top surface of the insulator film 55. The top surface of the insulator film 55 is parallel with the top surface of the channel-forming substrate 10.

The third piezoelectric layer portion 73 resides on each of the inclined portions 62 of the lower electrode film 60. The inclined portions 62 are angled toward the channel-forming substrate 10 at 5 to 50 degrees with respect to the top surface of the insulator film 55. In the first embodiment, the inclined portions 62 supporting the third piezoelectric layer portions 73 are angled at about 25 degrees.

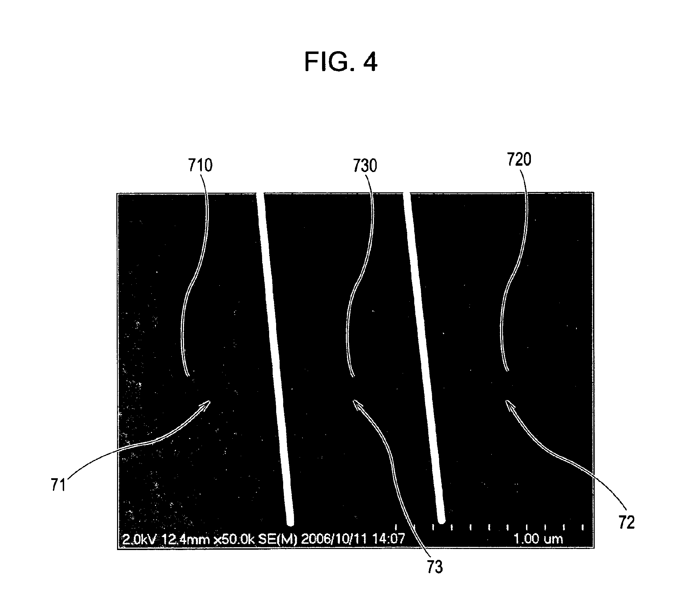

The columnar crystals 730 constituting the third piezoelectric layer portions 73 extend orthogonally to the surfaces of the inclined portions 62, but curve toward the upper electrode film 80 so as to extend orthogonally to the top surface of the channel-forming substrate 10. In other words, the columnar crystals 730 curve at halfway points such that portions 731 thereof near the lower electrode film 60 extend orthogonally to the surfaces of the inclined portions 62 whereas portions 732 thereof near the upper electrode film 80 extend orthogonally to the top surface of the channel-forming substrate 10. Fig. 4 schematically shows a surface taken along plane IV-IV in Fig. 3 for observation of grains of the columnar crystals 710, 720, and 730 respectively constituting the first, second, and third piezoelectric layer portions 71, 72, and 73 at their end faces proximate to the upper electrode film 80. As shown in Fig. 4, the widths (the horizontal lengths in Fig. 4) of the grains are larger in the columnar crystals 730 than in the columnar crystals 710 and 720. The width direction of the grains at the end faces of the columnar crystals 730 proximate to the upper electrode film 80 corresponds to the inclined direction of the inclined portions 62. In other words, the longitudinal direction of the grains at the end faces of the columnar crystals 730 proximate to the upper electrode film 80 is parallel with the inclined direction of the inclined portions 62. This provides the columnar crystals 730 with a higher strength than the columnar crystals 710 and 720 against a stress applied in the inclined direction of the inclined portions 62 from the lower electrode film 60 toward the upper electrode film 80 or in the opposite direction.

The lower electrode film 60 having the above-described shape can be formed by providing a material for the lower electrode film 60 over the entire top surface of the insulator film 55 by sputtering, for example, and patterning the resultant. The piezoelectric layer 70 can be formed by a sol-gel process or a metal-organic decomposition (MOD) process, for example. In such a case, the piezoelectric layer 70 is formed by applying and drying a sol, in which a metallo-organic compound is dissolved and dispersed in a solvent, so as to obtain a gel, and then firing the gel. The upper electrode film 80 can be formed by sputtering or the like.

In general, one of the two electrodes of the piezoelectric element 300 serves as a common electrode, while the other electrode and the piezoelectric layer 70 are patterned in correspondence with the pressure-generating chambers 12. In the resultant component consisting of the patterned electrode and the patterned piezoelectric layer 70, a region in which a piezoelectric strain occurs when a voltage is applied to both electrodes is referred to as the active piezoelectric region 320, and a region in which a piezoelectric strain does not occur even when a voltage is applied to both electrodes is referred to as an inactive piezoelectric region 321.

In the first embodiment, the active piezoelectric region 320 is constituted by the flat portion 61 of the lower electrode film 60, the first piezoelectric layer portion 71, and the upper electrode film 80. On the other hand, the inactive piezoelectric region 321 is constituted by the second piezoelectric layer portion 72, provided on the insulator film 55, and the upper electrode film 80. Further, the first embodiment includes an intermediate piezoelectric region 322 constituted by the inclined portion 62, the third piezoelectric layer portion 73, and the upper electrode film 80. That is, the intermediate piezoelectric region 322 is provided between the active piezoelectric region 320 and the inactive piezoelectric region 321. When a voltage is applied to the electrodes, the active piezoelectric region 320 is displaced whereas the inactive piezoelectric region 321 is not displaced. Therefore, a stress is applied to the intermediate piezoelectric region 322. Specifically, when a voltage is applied to the electrodes, a stress is applied to the columnar crystals 730 constituting the third piezoelectric layer portion 73 in the longitudinal direction (the inclined direction of the inclined portion 62) from the lower electrode film 60 toward the upper electrode film 80.

As described above, the columnar crystals 730 have a higher strength than the columnar crystals 710 and 720 against a stress applied in the inclined direction of the inclined portion 62 from the lower electrode film 60 toward the upper electrode film 80. Therefore, the actuator device 1 including the piezoelectric element 300 constituted as such can have higher reliability and durability. Accordingly, the ink jet recording head I including the actuator device 1 constituted as such can also have higher reliability and durability.

### Other Embodiments

The first embodiment has been described taking the ink jet recording head I as an exemplary liquid ejecting head. The invention is generally directed to liquid ejecting heads and can be applied to liquid ejecting heads that eject liquids other than ink, of course. Examples of such liquid ejecting heads include recording heads included in image recording apparatuses such as printers, colorant ejecting heads used in manufacturing color filters included in liquid crystal displays, electrode material ejecting heads used in forming electrodes included in organic electroluminescent (EL) displays and field emission displays (FEDs), and bioorganic substance ejecting heads used in manufacturing biochips.

In the first embodiment, the columnar crystals 730 constituting the third piezoelectric layer portion 73 extend orthogonally from the surfaces of the inclined portions 62, but curve toward the upper electrode film 80 so as to extend orthogonally to the top surface of the insulator film 55. However, the columnar crystals 730 may not necessarily have curves. The columnar crystals 730 only need to extend orthogonally from the surfaces of the inclined portions 62 and then bend toward the upper electrode film 80 so as to extend orthogonally to the top surface of the insulator film 55.

Further, the invention is not limited to actuator devices included in liquid ejecting heads, and can be applied to actuator devices included in other apparatuses.

## Claims

1. An actuator device comprising:
a piezoelectric element including a lower electrode, a piezoelectric layer, and an upper electrode that are displaceably provided in sequence on a substrate,
wherein the lower electrode includes a flat portion at a central region thereof and an inclined portion at an end thereof descending toward the substrate,
wherein the piezoelectric layer is disposed above the lower electrode and the substrate, and includes a first piezoelectric layer portion constituted by a plurality of columnar crystals extending orthogonally to a surface of the flat portion of the lower electrode, a second piezoelectric layer portion constituted by a plurality of columnar crystals extending orthogonally to a surface of the substrate, and a third piezoelectric layer portion constituted by a plurality of columnar crystals residing on the inclined portion between the first and second piezoelectric layer portions,
wherein the columnar crystals of the third piezoelectric layer portion extend orthogonally to a surface of the inclined portion and bend toward the upper electrode so as to extend orthogonally to the surface of the substrate, and
wherein grains of the columnar crystals constituting the third piezoelectric layer portion have larger widths than those of grains of the columnar crystals constituting the first and second piezoelectric layer portions at a surface of the piezoelectric layer proximate to the upper electrode.

2. The actuator device according to Claim 1, wherein the piezoelectric element includes an active piezoelectric region constituted by the first piezoelectric layer portion, an inactive piezoelectric region constituted by the second piezoelectric layer portion, and an intermediate piezoelectric region constituted by the third piezoelectric layer portion.

3. The actuator device according to Claim 1 or Claim 2,
wherein the grains of the columnar crystals constituting the third piezoelectric layer portion have larger widths than those of the grains of the columnar crystals constituting the first and second piezoelectric layer portions in a same direction.

4. The actuator device according to any one of preceding Claims 1-3, wherein a width direction of the grains of the columnar crystals constituting the third piezoelectric layer portion corresponds to an inclined direction of the inclined portion.

5. The actuator device according to any one of preceding Claims 1-4, wherein the inclined portion is inclined at 5 to 50 degrees with respect to the surface of the substrate.

6. The actuator device according to any one of preceding Claims 1-5, wherein the inclined portion has a length of 0.5 to 3 µm in the inclined direction.

7. The actuator device according to any one of preceding Claims 1-6, wherein the columnar crystals respectively constituting the first to third piezoelectric layer portions have perovskite structures.

8. A liquid ejecting head comprising:
a channel-forming substrate provided with a pressure-generating chamber communicating with a nozzle opening through which liquid is ejected; and
the actuator device according to any one of preceding Claims 1-7 serving as a liquid ejecting unit that is provided on one surface of the channel-forming substrate and causes a change of pressure in the pressure-generating chamber.
